# EUROPEAN PATENT APPLICATION

(11) **EP 4 818 664 A1**
(43) Date of publication of application: **07.10.2026**
(21) Application number: 26170462.1
(22) Date of filing: 02.04.2026
(51) Int. Cl.: G01M 3/16, G06F 1/20, G06F 1/28

(54) **HOST SYSTEM WITH A LIQUID DETECTOR**

(30) Priority: 03.04.2025 US 202519169773
(71) Applicant: Aivres Systems Inc., Fremont California 94538 (US)
(72) Inventor: KU, Kuang Jun, Fremont, CA 94538 (US)
(74) Representative: Fish & Richardson P.C.

(57) **Abstract**

Methods, devices, and systems for protecting a host system against coolant leaks are provided. In one aspect, a device includes a circuit, a comparator and a voltage regulator. The circuit includes a first resistor that includes a ground probe and a sense probe spaced apart from the ground probe. The first resistor has a resistance that varies based on a presence or absence of a liquid. The circuit is configured to provide a measurement voltage. The comparator is configured to generate an output signal having a first level that indicates the presence of the liquid. The voltage regulator includes a power controller and one or more power stages coupled to the power controller. The power controller is configured to: receive the output signal from the comparator; and in response to determining that the output signal has the first level, turn off the one or more power stages.

## Description

### TECHNICAL FIELD

The present disclosure is related to a host system.

### BACKGROUND

Computing devices, such as servers, are widely used in a variety of fields. In areas such as artificial intelligence (AI) and big data, the need for computing is growing rapidly. To improve flexibility and computational efficiencies, some computing devices are configured to include different external devices within the same server chassis, making the computing devices suitable for a variety of applications.

A computing device or server can include a voltage regulator. A voltage regulator can supply power to processors of the computing devices and ensure that the processors can receive the correct voltage level. The host system can generate significant heat during operation. A cooler may be used to help maintain an acceptable temperature level. The cooler can include a fan, liquid cooling system, or heat sink.

### SUMMARY

The present disclosure describes devices, systems and techniques for detecting a leakage of a liquid (e.g., coolant from a cooler) in a host system and, in response to a detection of the liquid, taking preventative actions (e.g., shutting down power stages) to protect the host system.

In an implementation, a device includes a circuit, a comparator and a voltage regulator. The circuit includes a first resistor that includes a ground probe and a sense probe spaced apart from the ground probe. The first resistor has a resistance that varies based on a presence or absence of a liquid. The circuit is configured to provide a measurement voltage indicating the resistance of the first resistor. The comparator is configured to generate an output signal based on a comparison result between the measurement voltage and a reference voltage. The output signal has one of a first level or a second level. The first level indicates the presence of the liquid, and the second level indicates the absence of the liquid. The voltage regulator includes a power controller and one or more power stages coupled to the power controller. The power controller is configured to: receive the output signal from the comparator; and in response to determining that the output signal has the first level, turn off the one or more power stages.

The described subject matter can be implemented using a computer-implemented method; a non-transitory, computer-readable medium storing computer-readable instructions to perform the computer-implemented method; and a computer-implemented system comprising one or more computer memory devices interoperably coupled with one or more computers and having tangible, non-transitory, machine-readable media storing instructions that, when executed by the one or more computers, perform the computer-implemented method/the computer-readable instructions stored on the non-transitory, computer-readable medium.

The subject matter described in this specification can be implemented to realize one or more of the following benefits, effect and/or advantages. For example, the implementations of the present disclosures can detect a leakage of a liquid coolant from a cooler in the host system and automatically shut down power stages to avoid or reduce damages to both power stages and processors. In implementations, a liquid detector is provided. The liquid detector includes a sensing probe that can sense the presence of the liquid coolant. The liquid detector can generate an electrical signal indicating the presence of the liquid and transmit the electrical signal to a power controller of the host system. In response to the electrical signal, the power controller can shut down the power stages to cut off its power supply to the processors. By shutting down the power stages, a risk of electrical shorts of the power stages caused by the presence of the liquid can be reduced. This, in turn, can reduce the risk of a surge in current or voltage supplied to the processors by the power stages, thereby protecting the processors.

The details of one or more implementations of the subject matter of this specification are set forth in the Detailed Description, the Claims, and the accompanying drawings. Other features, aspects, and advantages of the subject matter will become apparent to those of ordinary skill in the art from the Detailed Description, the Claims, and the accompanying drawings.

### DESCRIPTION OF DRAWINGS

FIG. 1 is a block diagram of an example of a host system with a liquid detector.
FIG. 2 illustrates the liquid detector and a voltage regulator of the host system of FIG. 1.
FIG. 3 illustrates an example of a circuit of the liquid detector of FIG. 2.
FIG. 4 illustrates a flow chart of an example of a method of detecting a liquid in a host system.
FIG. 5 is a block diagram illustrating an example architecture of a computing system.
FIG. 6 is a block diagram illustrating an example architecture of a computing device.

Like reference numbers and designations in the various drawings indicate like elements.

### DETAILED DESCRIPTION

The present disclosure describes a protection device and system to protect a host system against a liquid coolant leaked from a cooler. The host system can support general computation tasks, and/or high-performance computing (HPC) applications. The cooler can be used to maintain a temperature of the host system at an acceptable range during operation. The protection system can include a liquid detector that is coupled to a power controller of the host system. The liquid detector can include a sensing probe capable of detecting the presence of liquid coolant near power stages of the host system. The power stages can supply power to processors of the host system under the control of the power controller. Upon detecting the coolant, the liquid detector can generate an electrical signal indicating its presence and transmit the electrical signal to the power controller. In response to the electrical signal, the power controller can automatically shut down the power stages, effectively cutting off the power supply to the processors to help prevent or reduce potential damages to both the power stages and processors.

The following detailed description describes systems and techniques for a protection system to protect a host system from liquid coolant leaks and is presented to enable any person skilled in the art to make and use the disclosed subject matter in the context of one or more particular implementations. Various modifications, alterations, and permutations of the disclosed implementations can be made and will be readily apparent to those of ordinary skill in the art, and the general principles defined can be applied to other implementations and applications, without departing from the scope of the present disclosure. In some instances, one or more technical details that are unnecessary to obtain an understanding of the described subject matter and that are within the skill of one of ordinary skill in the art may be omitted so as to not obscure one or more described implementations. The present disclosure is not intended to be limited to the described or illustrated implementations, but to be accorded the widest scope consistent with the described principles and features.

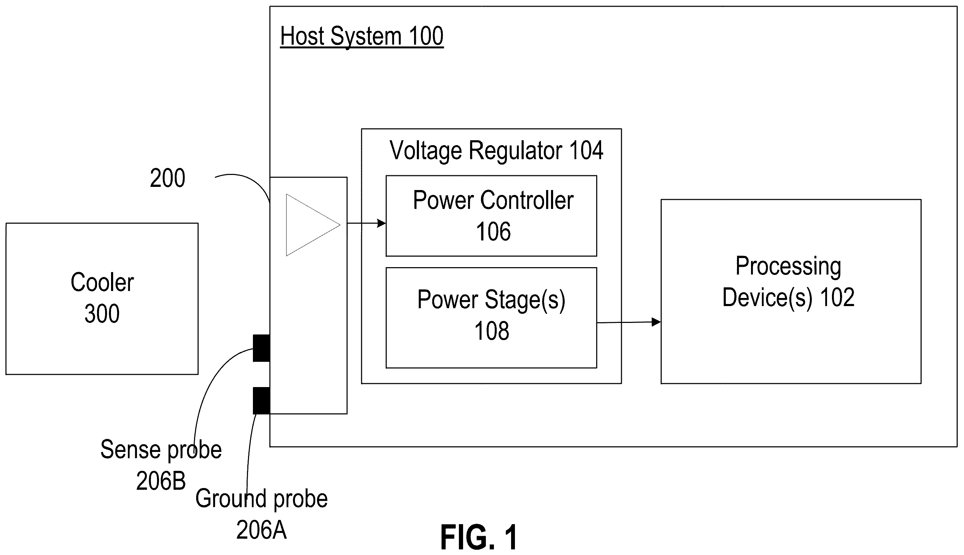

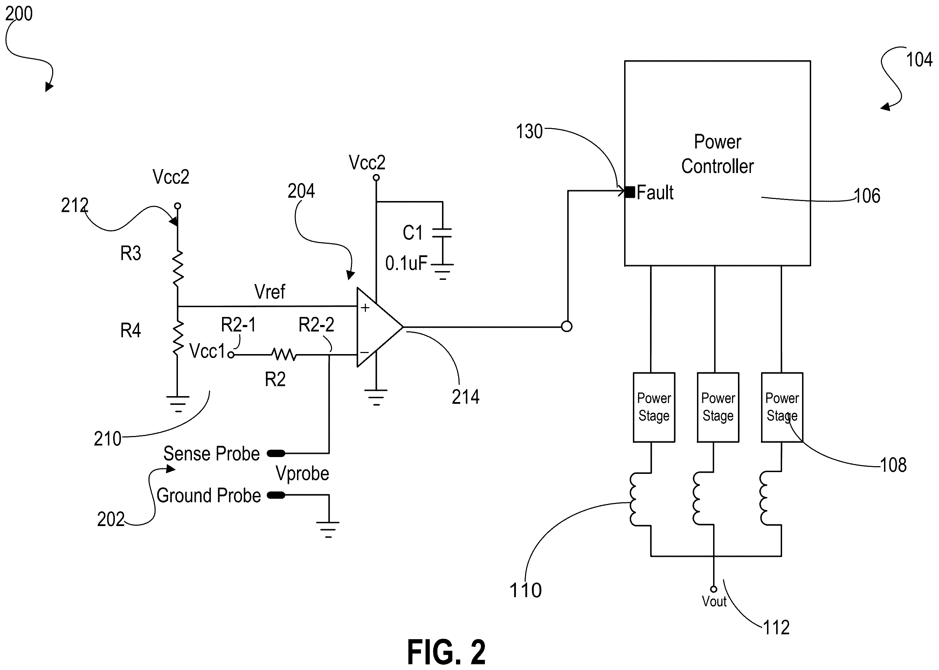

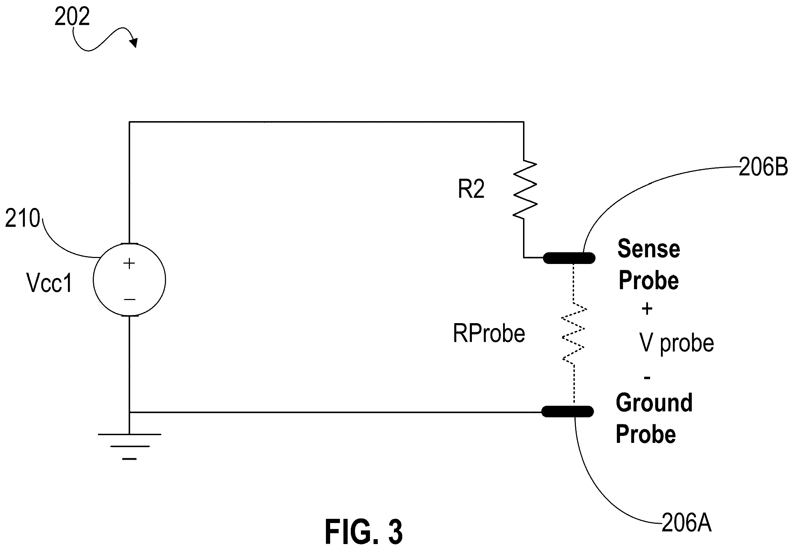

FIG. 1 illustrates a block diagram of a host system 100 with a liquid detector 200 according to one or more implementations. FIG. 2 illustrates the liquid detector and a voltage regulator of FIG. 1. FIG. 3 illustrates an example of a circuit of the liquid detector of FIG. 2. For ease of description, reference will be made to FIGS. 1-3 when describing the host system 100 and the liquid detector 200.

The host system 100 can be a computing system (such as a server) or a computing device (such as a computer). The host system 100 can be configured to support general computation tasks, high-performance computing (HPC) applications, deep learning applications, artificial intelligence (AI), and/or high storage capacity in flexible configurations. The host system 100 includes one or more processing devices 102. The one or more processing devices 102 can include, e.g., one or more central processing units (CPUs), one or more graphics processing units (GPUs), one or more data processing units (DPUs), one or more Application Specific Integrated Circuits (ASICs), one or more Field Programmable Gate Arrays (FPGAs), one or more multi-core processors, one or more microprocessors, one or more quantum processors, or a combination thereof. The processing devices 102 can also be referred to as processors in the present disclosure.

As illustrated in FIGS. 1 and 2, the host system 100 includes a voltage regulator 104. The voltage regulator 104 can be configured to supply a voltage and/or current to the processing devices 102. In some implementations, the voltage regulator 104 is a multi-phase regulator. A multi-phase regulator can divide load across multiple phases (e.g., 4, 6, 8, or more). Each phase can take turn supplying power in sequence.

The voltage regulator 104 can include a power controller 106 and one or more power stages 108 coupled to the power controller 106. The example implementation in FIG. 2 shows three power stages 108, but the number of the power stages 108 is not limited thereto. The power controller 106 can be configured to coordinate power distribution across multiple power stages 108 to ensure a stable voltage output. Each power stage 108 can correspond to a respective phase of the multiple phases of the voltage regulator 104. In some examples, the power stage 108 can include a MOSFET for controlling the flow of electrical current and a driver circuit that controls the switching operation of the MOSFET.

In some implementations, each of the power stages 108 is coupled to an inductor 110. The inductor 110 can be configured to store energy and help smooth out fluctuations in voltage. The inductors 110 can be connected to a single output 112. In some implementations, the voltage regulator 104 is configured to output a direct current (DC) voltage and/or current to the processing devices 102. In some implementations, the voltage regulator 104 is configured to supply the voltage to the at least one processing device 102 at a current level equal to or greater than 500 amperes.

Returning to FIG. 1, during operation, the power stages 108 can generate heat. As the power demand increases (e.g., high CPU/GPU workloads), the heat output may rise significantly, sometimes exceeding 100 °C in extreme conditions. Excessive heat can cause the failure of the power stages 108. Therefore, a cooler 300 may be needed to decrease the temperature surrounding the power stages 108 to maintain the temperature within an acceptable range. In some examples, the cooler 300 includes a cold plate with channels through which a liquid coolant flows. The cold plate of the cooler 300 can be placed at or near the power stages 108. When the coolant flows through the channels of the cold plate, it can absorb and carry away the heat produced by the power stages 108. The cooler 300 can additionally include a radiator. The coolant can flow through the cold plate to the radiator, where the heat is released to the outside air. The coolant can then return to the cold plate for recirculation. It is to be noted that other configurations of the cooler 300 are also possible. Examples of the coolant include antifreeze or propylene glycol, but is not limited thereto.

In some situations, the coolant may leak from the cooler 300. If the power stages are not shut down promptly, the leaked coolant can lead to short-circuits, corrosion, and component failures in the power stages 108. Short circuits in the power stages 108 can also cause a surge in current or voltage supplied to the processing devices 102, thereby potentially damaging the processing devices 102. The implementations of the present disclosure provide a liquid detector 200 configured to (i) detect a leakage of coolant, and (ii) upon detecting the coolant, to automatically shut down the power stages 108 to cut off the power supply to the processing devices 102 to protect both the power stages 108 and the processing devices 102. The liquid detector 200 is described below in reference to FIGS. 1 to 3.

As illustrated in FIG. 2, the liquid detector 200 includes a circuit 202 and a comparator 204. The output of the comparator 204 is coupled to an input pin 130 of the power controller 106. Referring now to FIG. 3, the circuit 202 includes a first resistor RProbe, a second resistor R2 and a power source 210 that are connected in series. The first resistor RProbe includes a ground probe 206A and a sense probe 206B spaced apart from the ground probe 206A. The sense probe 206B or the ground probe 206A can be a conductive pad that is made of a material, including without limitation to, copper, copper alloy, silver, and/or aluminum. The sense probe 206B or the ground probe 206A can have a size in a range from a few millimeters to several centimeters (or from a fraction of an inch to several inches) but is not limited thereto. The sense probe 206B or the ground probe 206A can have any suitable shape, e.g., a square shape, a circular shape, an elliptical shape, a rectangular shape, or any regular or irregular shapes.

The sense probe 206B is coupled to the second resistor R2, and the ground probe 206A is coupled to the ground or a ground voltage level (e.g., 0 V). The sense probe 206B and the ground probe 206A can be placed on one or more dielectric surfaces such that they are not electrically connected through the surface(s) on which they are placed. The sense probe 206B can be spaced apart from the ground probe 206A at a distance of 5 mm or less, 10 mm or less, 15 mm or less, 30 mm or less, or 50 mm or less. A distance between the sense probe 206B and the ground probe 206A can be defined as a minimum distance between any point on the sense probe 206B and any point on the ground probe 206A.

In some implementations, the sense probe 206B is positioned adjacent to the one or more power stages 108. For example, the sense probe 206B can be placed on the power stages 108, or at a distance of 100mm or less, 50 mm or less, 10mm or less, or 3mm or less from the power stages 108. In the example implementations where the voltage regulator 104 has two or more power stages 108, the sense probe 206B can be placed on or adjacent to any one of the power stage 108, or on the power stage 108 nearest to the cooler 300. In some implementations, the sense probe 206B is positioned between the cooler 300 and the nearest power stage 108.

The first resistor RProbe has an electrical resistance that varies based on a presence or absence of a liquid (e.g., the coolant) between the ground probe 206A and the sense probe 206B. For example, when the liquid is not present between the ground probe 206A and the sense probe 206B, the ground probe 206A can be electrically isolated from the sense probe 206B. Therefore, the first resistor RProbe can be effectively in an open-circuit state and have a first resistance value. In some examples, the first resistance value is about 1 MΩ. In contrast, when the liquid is present between the ground probe 206A and the sense probe 206B and connects both probes, the ground probe 206A and the sense probe 206B can be electrically shorted. Therefore, the first resistor RProbe can be effectively in a short-circuit state and have a second resistance value that is smaller than the first resistance value (e.g., less than 1 MΩ).

It is to be noted that, in some situations, a liquid may be present between the ground probe 206A and the sense probe 206B but without electrically shorting the two probes. For example, a small droplet may be present between the two probes without making contact with either probe, and the resistive value of the first resistor RProbe does not vary substantially by the presence of the droplet (e.g., varying by 10% or less, 5% or less, or 3% or less). In such situations, the liquid may be considered effectively "absent" between two probes for the purpose of the descriptions of the present disclosure.

It is further to be noted that a liquid can be considered "present" between two probes as long as the liquid electrically shorts the two probes, even if the liquid is not physically located between two probes. For examples, a liquid pod may be located outside the space between the two probes, but edges of the liquid pod can be in contact with both probes. Although the space between the two probes may not be directly occupied by the liquid, the liquid can still be considered effectively "present" between the two probes. As used herein, the liquid is considered to be "electrically shorting" the two probes when its presence decreases the resistance value of the first resistor RProbe by 10% or more, 20% or more, 50% or more, or 70% or more.

With continued reference to FIG. 3, the second resistor R2 is coupled to the sense probe 206B. In some implementations, the second resistor R2 has a resistance value that is substantially equal to the first resistance value of the first resistor RProbe when the liquid is absent (e.g., in the open-circuit state). In some implementations, the second resistor R2 has a resistance value in a range between 0.8 megohms (MΩ) and 1.2 MΩ, between 0.5 MΩ and 1.5 MΩ, or between 0.3 MΩ and 2 MΩ. In some implementations, the second resistor R2 has a resistance value of 1 MΩ.

The power source 210 can supply a positive voltage Vcc1 that is generally used in transistor-based circuits. For example, the voltage Vcc1 can be between 1V and 10V, 2V and 8V, or between 3V and 7V. In some implementations, Vcc1 is 5 V.

Returning to FIG. 2, the second resistor R2 has a first end R2-1 and a second end R2-2. The first end R2-1 of the second resistor R2 is coupled to the power source 210, while the second end R2-2 of the second resistor R2 is coupled to both the first resistor RProbe and a first input end (e.g., an inverting input end "-") of the comparator 204. The circuit 202 is configured to provide a measurement voltage indicating the resistance value of the first resistor RProbe to the input end of the comparator 204. The measurement voltage can be the voltage across the first resistor RProbe. As the resistance of the first resistor RProbe changes depending on the presence or absence of the liquid, the measurement voltage varies correspondingly. For example, when no liquid is present between the sense probe 206B and the ground probe 206A (e.g., in the open-circuit state), the first resistor RProbe has the first resistance value, and the circuit 202 outputs a first measurement voltage reflective of the first resistance value. In an example, if the first resistance value of the first resistor RProbe is 1 MΩ, and the second resistor R2 has a resistance value of 1 MΩ, the first measurement voltage is about 2.5 V. In contrast, when the liquid is present between the sense probe 206B and the ground probe 206A (e.g., in a short-circuit state), the first resistor RProbe has the second resistance value. The circuit 202 can then output a second measurement voltage reflective of the second resistance value. The second measurement voltage can be smaller than the first measurement voltage (e.g., less than 2.5V).

The first input end (e.g., the inverting input end) of the comparator 204 is configured to receive the measurement voltage from the circuit 202. A second input end (e.g., a non-inverting input end "+") of the comparator 204 is configured to receive a reference voltage, e.g., from a voltage divider circuit 212. In some implementations, the reference voltage is equal to the first measurement voltage of the first resistor RProbe. For example, the reference voltage can be 2.5V. The voltage divider circuit 212 can reduce a voltage (e.g., Vcc2) to a lower level using two resistors (e.g., the third and fourth resistors R3, R4) that are connected in series. The third and fourth resistors R3, R4 can have equal resistance values. The resistance value of each of the third and fourth resistors R3, R4 can be between 0.5 KΩ and 1 MΩ (e.g., 100 KΩ), but the resistance value is not limited thereto. In some implementations, the voltage divider circuit 212 is configured to output the reference voltage equal to half of a second voltage Vcc2. The voltage Vcc2 can be equal to the voltage Vcc1 supplied by the power source 210 (e.g., 5V).

With continued reference to FIG. 2, the comparator 204 is configured to generate an output signal based on a comparison result between the measurement voltage and the reference voltage. The output signal has one of a first voltage level or a second voltage level. The first voltage level can indicate the presence of the liquid, while the second voltage level can indicate the absence of the liquid. In some implementations, the comparator 204 is configured to, (i) based on the measurement voltage being smaller than the reference voltage, generate the output signal having the first voltage level, and (i) based on the measurement voltage being greater than or equal to the reference voltage, generate the output signal having the second voltage level that is greater than the first voltage level. The output signal can be a DC voltage signal with a voltage value depending on the comparison result. For example, when the measurement voltage is smaller than the reference voltage, the output signal generated by the comparator 204 can have a low voltage level (e.g., 0V). When the measurement voltage is greater than the reference voltage, the output signal generated by the comparator 204 can have a high voltage level (e.g., 5V). The comparator 204 can be an open-collector comparator, a push-pull comparator, a high-speed comparator, a precision comparator, or any other suitable comparators.

The output end 214 of the comparator 204 is coupled to the input pin 130 of the power controller 106. The power controller 106 is configured to receive the output signal from the comparator 204 at the input pin 130. The power controller 106 is configured to, (i) in response to determining that the output signal has the first voltage level, turn off the one or more power stages 108, and/or (ii) in response to determining that the output signal has the second voltage level, maintain a current operation status of the one or more power stages 108. For example, when the output signal of the comparator 204 has the first voltage level indicating the presence of the liquid, the power controller 106 can shut down the power stages 108 to cut off the power supply to the processing devices 102. By shutting down the power stages 108, a risk of electrical shorts caused by the presence of the liquid can be reduced. This, in turn, can reduce the risk of a surge in current or voltage supplied to the processing devices 102, thereby protecting the processing devices 102. In contrast, when the output signal of the comparator 204 has the second voltage level that indicates the absence of the liquid, the power controller 106 can maintain the current operation status of the power stages 108 (e.g., keep the power stages 108 running, or make the power stages 108 remain shut down). Therefore, the implementations of the present disclosure can protect both the voltage regulator 104 and the processing devices 102 in the event of coolant leakage from the cooler 300.

In some implementations, as illustrated in FIG. 2, the liquid detector 200 and the input pin 130 of the power controller 106 are positioned on a same side of the voltage regulator 104. Having the liquid detector 200 and the input pin 130 of the power controller 106 placed at the same side can reduce electrically wiring, thereby simplifying circuit design and reduce signal transmission latency. Here, the liquid detector 200 can be considered as being on the same side as the input pin 130 when at least the comparator 204 of the liquid detector 200 is positioned on that side. The comparator 204 of the liquid detector 200 can be considered as being on the same side as the input pin 130 when they are not positioned on opposite sides of the power controller.

A number of implementations have been described in reference to FIGS. 1-3. Nevertheless, it will be understood that various modifications may be made without departing from the spirit and scope of the disclosure.

While the voltage regulator 104 has been described as a multi-phase regulator, in some implementations, the voltage regulator 104 can be a single phase regulator, a buck regulator, a boost regulator, a buck-boost regulator, a linear regulator, a synchronous regulator, a non-synchronous regulator, or any other suitable regulators.

While the voltage regulator 104 has been described as supplying the power to the one or more processing devices 102, the voltage regulator 104 can also supply the power to other devices in the host system. For example, the voltage regulator 104 can supply power to a baseboard management controller (BMC), memory devices, peripheral component interconnect express (PCIe) switch, and/or PCIe devices that are coupled to the PCIe switch. By automatically shutting down the power stages in response to a detection of the coolant, the voltage regulator 104 can also protect other devices connected to it.

In some implementations, the coolant is liquid. As used herein, the liquid can have a broad meaning and encompass any state of matter that has the ability to flow and conform to the shape of a container. The liquid can vary in viscosity, density, and chemical compositions. The liquid can also refer to any substance that exists in a liquid state at a given temperature and/or pressure, but transitions to a non-liquid state under different temperature and/or pressure conditions. For example, a phase-change coolant can be considered as a liquid, where the phase-change coolant can change between liquid and gas, between liquid and solid, or between solid, liquid and gas to carry heat away from the host system.

While the circuit 202 has been described as having a single pair of the sense probe 206B and the ground probe 206A, in some implementations, the circuit 202 can have a plurality of pairs of the sense probe 206B and the ground probe 206A. The plurality of pairs of probes can be placed at different places, e.g., with each pair being placed adjacent to a different power stage 108. The plurality of pairs of probes can be coupled to one another in series and/or in parallel.

While the sense probe 206B or the ground probe 206A has been described as a pad, they can have any other suitable geometric shapes. For example, the probes can be cylindrical, spherical, or have a three-dimensional (3D) geometric shape like a block, a cone, a helix, a coil, a protruding pin, or a mesh pattern.

While the second resistor R2 has been described as having a resistance value substantially equal to the first resistance value of the first resistor RProbe when the first resistor RProbe is in the open-circuit state, in some implementations, the resistance value of second resistor R2 can be different from the first resistance value of the first resistor RProbe. For example, the resistance value of second resistor R2 can be one-third, one half, or twice the first resistance value of the first resistor RProbe.

While the second resistor R2 has been described as having a resistance value between 0.8 MΩ and 1.2 MΩ, between 0.5 MΩ and 1.5 MΩ, or between 0.2 MΩ and 2 MΩ, other resistance values are also possible. For example, the resistance R2 can be between 1 KΩ and 100 KΩ, between 100 KΩ and 500 KΩ, between 500 KΩ and 800 KΩ, or between 2 MΩ and 5 MΩ.

While the comparator 204 has been described as receiving the measurement voltage at its inverting input end and receiving the reference voltage at its non-inverting input end, in some implementations, these inputs can be reversed. For example, the comparator 204 can be configured to receive the measurement voltage at its non-inverting input end while receiving the reference voltage at its inverting input end.

While the reference voltage has been described as being substantially equal to the first measurement voltage (e.g., the measurement voltage when the liquid is absent), in some implementations, the reference voltage can be substantially equal to the second measurement voltage (e.g., the measurement voltage when the liquid is present).

While the comparator 204 has been described as generating the electrical signal (i) having the first voltage level indicating the presence of the liquid and/or (ii) having the second voltage level indicating the absence of the liquid, and the second voltage level is greater than the first voltage level, in some implementations, the second voltage level is lower than the first voltage level.

While the power controller 106 has been described as being coupled to one liquid detector 200, in some implementations, the power controller 106 can be coupled to multiple liquid detectors 200, and each liquid detector 200 can be configured to detect the liquid at a different location.

While the power controller 106 has been described as shutting down all power stages 108 based on the output signal of the comparator 204 having the first voltage level, in some implementations, the power controller 106 is configured to shut down some of the power stages 108 while keep the remaining power stages 108 running. For example, in example implementations where a single liquid detector 200 has multiple pairs of probes, or multiple liquid detectors 200 are used in the host system 100, the power controller 106 can be configured to selectively shut down only the power stages 108 that are adjacent to the probes or the liquid detector 200 that has detected the presence of the liquid.

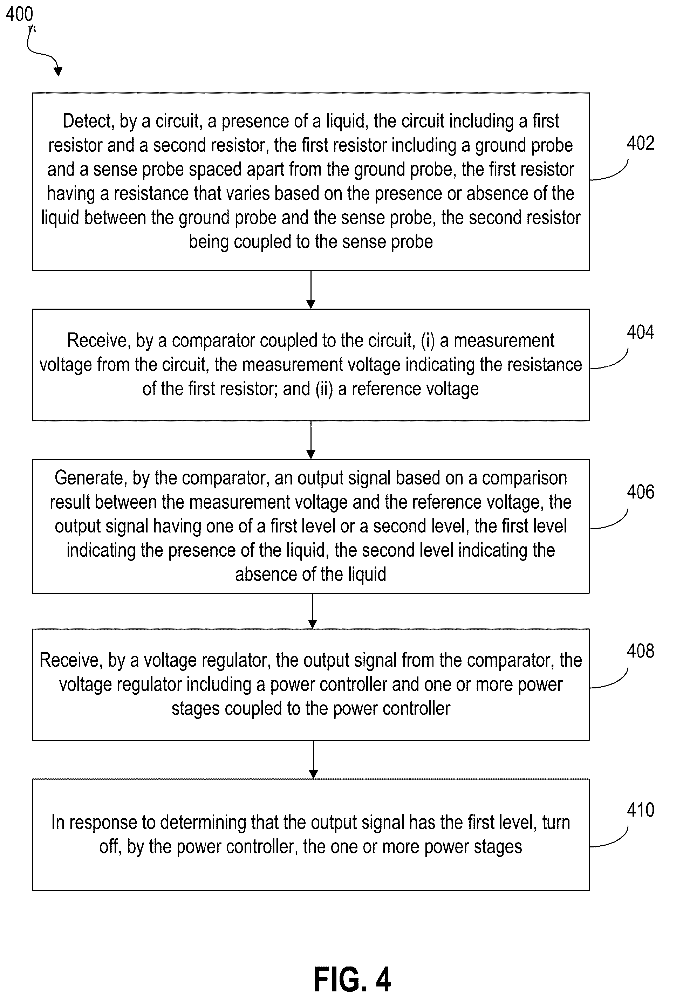

FIG. 4 illustrates a flow chart of an example of a method 400 of detecting a liquid in a host system. The host system can be, e.g., the host system 100 of FIG. 1.

At step 402, a presence of a liquid is detected by a circuit. The circuit includes a first resistor and a second resistor. The first resistor includes a ground probe and a sense probe spaced apart from the ground probe. The first resistor has a resistance that varies based on the presence or absence of the liquid (e.g., coolant) between the ground probe and the sense probe. The second resistor is coupled to the sense probe. The circuit can be, e.g., the circuit 202 of FIGS. 2 and 3. The first resistor can be, e.g., the first resistor RProbe of FIGS. 2 and 3. The ground probe can be, e.g., the ground probe 206A of FIGS. 2 and 3. The sense probe can be, e.g., the sense probe 206B of FIGS. 2 and 3. The second resistor can be, e.g., the second resistor R2 of FIGS. 2 and 3.

At step 404, a measurement voltage and a reference voltage are received by a comparator coupled to the circuit. The measurement voltage indicates the resistance of the first resistor. The comparator can be, e.g., the comparator 204 of FIGS. 2 and 3.

At step 406, an output signal is generated by the comparator based on a comparison result between the measurement voltage and the reference voltage. The output signal has one of a first level or a second level. The first level indicates the presence of the liquid, and the second level indicates the absence of the liquid, as described above in reference to FIGS. 2 and 3.

At step 408, the output signal is received by a voltage regulator from the comparator. The voltage regulator includes a power controller and one or more power stages coupled to the power controller. The voltage regulator can be, e.g., the voltage regulator 104 of FIGS. 1 and 2. The power controller can be, e.g., the power controller 106 of FIGS. 1 and 2. The power stages can be, e.g., the power stages 108 of FIGS. 1 and 2.

At step 410, in response to determining that the output signal has the first level, the one or more power stages are turned off by the power controller, as described in reference to FIGS. 1-3.

In some implementations, the method 400 includes, in response to determining that the output signal has the second level, maintaining a current operation status of the one or more power stages, as described above in reference to FIGS. 1-3.

In some implementations, the method 400 includes based on the measurement voltage being smaller than the reference voltage, generating the output signal having the first level; and based on the measurement voltage being greater than or equal to the reference voltage, generating the output signal having the second level, as described above in reference to FIGS. 1-3.

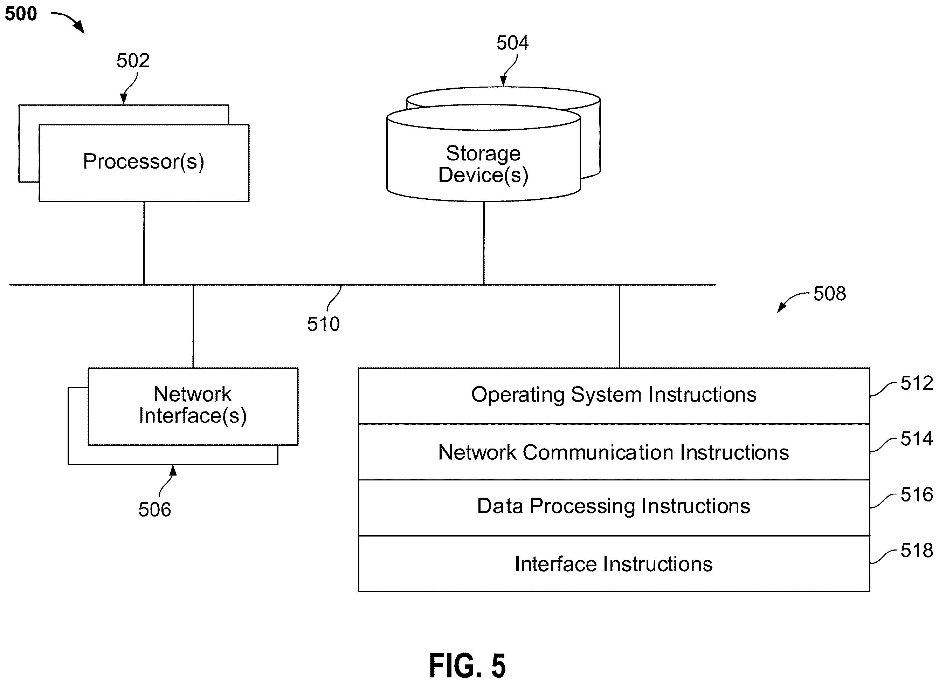

FIG. 5 is a block diagram illustrating an example architecture 500 of a computing system used to provide computational functionalities associated with described algorithms, methods, functions, processes, flows, and procedures. The computing system can be implemented as the host system 100 of FIG. 1. Other architectures are possible, including architectures with more or fewer components.

In some implementations, architecture 500 includes one or more processor(s) 502 (e.g., dual-core Intel^{®} Xeon^{®} Processors), one or more network interface(s) 506, one or more storage device(s) 504 (e.g., hard disk, optical disk, flash memory) and one or more computer-readable medium(s) 508 (e.g., hard disk, optical disk, flash memory, etc.). These components can exchange communications and data over one or more communication channel(s) 510 (e.g., buses), which can utilize various hardware and software for facilitating the transfer of data and control signals between components.

The computing system can, for example, use a PCIe switch between the processors 502 and storage devices 504, where the processors 502 can be host devices and the storage devices can be PCIe devices. In some examples, the computing system can use a PCIe switch between processors 502, e.g., CPUs and GPUs, where the CPUs can be host devices and GPUs can be PCIe devices. In some other examples, the computing system can use a PCIe switch between processors 502 and network interfaces 506, where the processors can be host devices and the network interfaces 506 can be PCIe devices.

The term "computer-readable medium" refers to any medium that participates in providing instructions to the processor(s) 502 for execution, including without limitation, non-volatile media (e.g., optical or magnetic disks), volatile media (e.g., memory) and transmission media. Transmission media includes, without limitation, coaxial cables, copper wire, and fiber optics.

Computer-readable medium(s) 508 can further include instructions 512 for an operating system (e.g., Mac OS^{®} server, Windows^{®} NT server, Linux Server), instructions 514 for network communications module, data processing instructions 516, and interface instructions 518.

Operating systems can be multi-user, multiprocessing, multitasking, multithreading, real time, etc. Operating system performs basic tasks, including but not limited to: recognizing input from and providing output to devices 502, 504, 506 and 508; keeping track and managing files and directories on computer-readable medium(s) 508 (e.g., memory or a storage device); controlling peripheral devices; and managing traffic on the one or more communication channel(s) 510. Network communications module includes various components for establishing and maintaining network connections (e.g., software for implementing communication protocols, such as TCP/IP, HTTP, etc.) and for creating a distributed streaming platform using, for example, Apache Kafka^{™}. Data processing instructions 516 include server-side or backend software for implementing the server-side operations. Interface instructions 518 includes software for implementing a web server and/or portal for sending and receiving data to and from user side computing devices and service side computing devices.

Architecture 500 can be implemented by a cloud computing system and can be included in any computer device, including one or more server computers in a local or distributed network each having one or more processing cores. Architecture 500 can be implemented in a parallel processing or peer-to-peer infrastructure or on a single device with one or more processors. Software can include multiple software components or can be a single body of code.

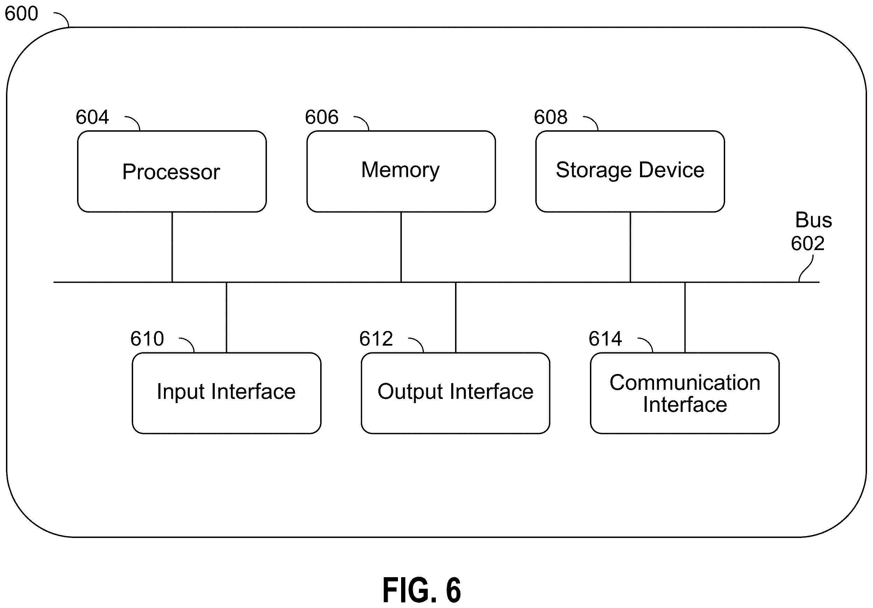

FIG. 6 is a block diagram illustrating an example architecture of a computing device 600 used to provide computational functionalities associated with described algorithms, methods, functions, processes, flows, and procedures. The computing device 600 can be implemented as the host system 100 of FIG. 1. Other architectures are possible, including architectures with more or fewer components.

The computing device 600 includes processor 604, memory 606, storage component 608, input interface 610, output interface 612, communication interface 614, and bus 602. For example, the computing device 600 can use a PCIe switch between the processor 604 and the storage device 608 and/or the communication interface 614, where the process 604 can be a host device and the storage component 608 and the communication interface 614 can be PCIe device(s).

Bus 602 includes a component that permits communication among the components of the computing device 600. In some embodiments, processor 604 is implemented in hardware, software, or a combination of hardware and software. In some examples, processor 604 includes a processor (e.g., a central processing unit (CPU), a graphics processing unit (GPU), an accelerated processing unit (APU), and/or the like), a microphone, a digital signal processor (DSP), and/or any processing component (e.g., a field-programmable gate array (FPGA), an application specific integrated circuit (ASIC), and/or the like) that can be programmed to perform at least one function. Memory 606 includes random access memory (RAM), read-only memory (ROM), and/or another type of dynamic and/or static storage device (e.g., flash memory, magnetic memory, optical memory, and/or the like) that stores data and/or instructions for use by processor 604.

Storage component 608 stores data and/or software related to the operation and use of the computing device 600. In some examples, storage component 608 includes a hard disk (e.g., a magnetic disk, an optical disk, a magneto-optic disk, a solid state disk, and/or the like), a compact disc (CD), a digital versatile disc (DVD), a floppy disk, a cartridge, a magnetic tape, a CD-ROM, RAM, PROM, EPROM, FLASH-EPROM, NV-RAM, and/or another type of computer readable medium, along with a corresponding drive.

Input interface 610 includes a component that permits the computing device 600 to receive information, such as via user input (e.g., a touchscreen display, a keyboard, a keypad, a mouse, a button, a switch, a microphone, a camera, and/or the like). Additionally or alternatively, in some embodiments input interface 610 includes a sensor that senses information (e.g., a global positioning system (GPS) receiver, an accelerometer, a gyroscope, an actuator, and/or the like). Output interface 612 includes a component that provides output information from the computing device 600 (e.g., a display, a speaker, one or more light-emitting diodes (LEDs), and/or the like).

In some embodiments, communication interface 614 includes a transceiver-like component (e.g., a transceiver, a separate receiver and transmitter, and/or the like) that permits the computing device 600 to communicate with other devices via a wired connection, a wireless connection, or a combination of wired and wireless connections. In some examples, communication interface 614 permits the computing device 600 to receive information from another device and/or provide information to another device. In some examples, communication interface 614 includes an Ethernet interface, an optical interface, a coaxial interface, an infrared interface, a radio frequency (RF) interface, a universal serial bus (USB) interface, a Wi-Fi^{®} interface, a cellular network interface, and/or the like.

In some embodiments, the computing device 600 performs one or more processes described herein. The computing device 600 performs these processes based on processor 604 executing software instructions stored by a computer-readable medium, such as memory 606 and/or storage component 608. A computer-readable medium (e.g., a non-transitory computer readable medium) is defined herein as a non-transitory memory device. A non-transitory memory device includes memory space located inside a single physical storage device or memory space spread across multiple physical storage devices.

In some embodiments, software instructions are read into memory 606 and/or storage component 608 from another computer-readable medium or another device via communication interface 614. When executed, software instructions stored in memory 606 and/or storage component 608 cause processor 604 to perform one or more processes described herein. Additionally or alternatively, hardwired circuitry is used in place of or in combination with software instructions to perform one or more processes described herein. Thus, embodiments described herein are not limited to any specific combination of hardware circuitry and software unless explicitly stated otherwise.

Memory 606 and/or storage component 608 includes data storage or at least one data structure (e.g., a database and/or the like). The computing device 600 is capable of receiving information from, storing information in, communicating information to, or searching information stored in the data storage or the at least one data structure in memory 606 or storage component 608. In some examples, the information includes network data, input data, output data, or any combination thereof.

In some embodiments, the computing device 600 is configured to execute software instructions that are either stored in memory 606 and/or in the memory of another device (e.g., another device that is the same as or similar to the computing device 600). As used herein, the term "module" refers to at least one instruction stored in memory 606 and/or in the memory of another device that, when executed by processor 604 and/or by a processor of another device (e.g., another device that is the same as or similar to the computing device 600) cause the computing device 600 (e.g., at least one component of the computing device 600) to perform one or more processes described herein. In some embodiments, a module is implemented in software, firmware, hardware, and/or the like.

The number and arrangement of components illustrated in FIG. 6 are provided as an example. In some embodiments, the computing device 600 can include additional components, fewer components, different components, or differently arranged components than those illustrated in FIG. 6. Additionally or alternatively, a set of components (e.g., one or more components) of the computing device 600 can perform one or more functions described as being performed by another component or another set of components of the computing device 600.

Described implementations of the subject matter can include one or more features, alone or in combination.

For example, in a first implementation, a device includes: a circuit including: a first resistor, where the first resistor includes a ground probe and a sense probe spaced apart from the ground probe, where the first resistor has a resistance that varies based on a presence or absence of a liquid between the ground probe and the sense probe; and a second resistor coupled to the sense probe, where the circuit is configured to provide a measurement voltage indicating the resistance of the first resistor; a comparator configured to: receive the measurement voltage and a reference voltage; and generate an output signal based on a comparison result between the measurement voltage and the reference voltage, where the output signal has one of a first level or a second level, the first level indicates the presence of the liquid, and the second level indicates the absence of the liquid; and a voltage regulator including a power controller and one or more power stages coupled to the power controller, where the power controller is configured to: receive the output signal from the comparator; and in response to determining that the output signal has the first level, turn off the one or more power stages.

The foregoing and other described implementations can each, optionally, include one or more of the following features:
A first feature, combinable with any of the following features, where the power controller is configured to, in response to determining that the output signal has the second level, maintain a current operation status of the one or more power stages.

A second feature, combinable with any of the previous or following features, where the comparator is configured to: based on the measurement voltage being smaller than the reference voltage, generate the output signal having the first level; and based on the measurement voltage being greater than or equal to the reference voltage, generate the output signal having the second level.

A third feature, combinable with any of the previous or following features, where the first level is lower than the second level.

A fourth feature, combinable with any of the previous or following features, where the second resistor has a resistance in a range between 0.8 megohms and 1.2 megohms.

A fifth feature, combinable with any of the previous or following features, where the sense probe is spaced apart from the ground probe by a distance smaller than or equal to 10 mm.

A sixth feature, combinable with any of the previous or following features, where the voltage regulator includes a multi-phase voltage regulator configured to: supply a voltage to at least one processor; and in response to determining that the output signal has the first level, terminate the voltage supplied to the at least one processor.

A seventh feature, combinable with any of the previous or following features, where the voltage regulator is configured to supply the voltage to the at least one processor at a current level equal to or greater than 500 amperes.

An eighth feature, combinable with any of the previous or following features, where the voltage regulator includes one or more inductors coupled to corresponding one or more power stages.

A ninth feature, combinable with any of the previous or following features, where the comparator is configured to receive the reference voltage from a voltage divider circuit.

In a second implementation, a system includes: one or more processors; and a voltage regulator including a power controller and one or more power stages coupled to the power controller, where the voltage regulator is configured to supply a voltage to the one or more processors; a liquid detector coupled to the voltage regulator and including: a circuit including: a first resistor, where the first resistor includes a ground probe and a sense probe spaced apart from the ground probe, the first resistor has a resistance that varies based on a presence or absence of a liquid between the ground probe and the sense probe; and a second resistor coupled to the sense probe, where the circuit is configured to provide a measurement voltage indicating the resistance of the first resistor; and a comparator configured to receive the measurement voltage and a reference voltage and generate an output signal based on a comparison result between the measurement voltage and the reference voltage, where the output signal has one of a first level or a second level, the first level indicates the presence of the liquid, and the second level indicates the absence of the liquid; and where the power controller of the voltage regulator is configured to (i) receive, from the comparator, the output signal, and (ii) in response to determining that the output signal has the first level, terminate the voltage supplied to the one or more processors by turning off the one or more power stages.

The foregoing and other described implementations can each, optionally, include one or more of the following features:
A first feature, combinable with any of the following features, where the power controller is configured to, in response to determining that the output signal has the second level, maintain a current operation status of the one or more power stages.

A second feature, combinable with any of the previous or following features, where the comparator is configured to: based on the measurement voltage being smaller than the reference voltage, generate the output signal having the first level; and based on the measurement voltage being greater than or equal to the reference voltage, generate the output signal having the second level.

A third feature, combinable with any of the previous or following features, where the sense probe is spaced apart from the ground probe by a distance smaller than or equal to 10 mm.

A fourth feature, combinable with any of the previous or following features, where the sense probe is positioned adjacent to the one or more power stages.

A fifth feature, combinable with any of the previous or following features, where the system includes a cooler including the liquid and disposed adjacent to the one or more power stages, where the cooler is configured to decrease a temperature surrounding the one or more power stages, where the sense probe is positioned between the cooler and the one or more power stages.

A sixth feature, combinable with any of the previous or following features, where the voltage regulator includes an input pin configured to receive the output signal of the comparator, and where the liquid detector and the input pin are positioned on a same side of the voltage regulator.

A seventh feature, combinable with any of the previous or following features, where the voltage regulator includes a multi-phase voltage regulator.

In a third implementation, a method includes: detecting, by a circuit, a presence of a liquid, the circuit including a first resistor and a second resistor, the first resistor including a ground probe and a sense probe spaced apart from the ground probe, the first resistor having a resistance that varies based on the presence or absence of the liquid between the ground probe and the sense probe, the second resistor being coupled to the sense probe; receiving, by a comparator coupled to the circuit, (i) a measurement voltage from the circuit, the measurement voltage indicating the resistance of the first resistor; and (ii) a reference voltage; generating, by the comparator, an output signal based on a comparison result between the measurement voltage and the reference voltage, the output signal having one of a first level or a second level, the first level indicating the presence of the liquid, the second level indicating the absence of the liquid; receiving, by a voltage regulator, the output signal from the comparator, the voltage regulator including a power controller and one or more power stages coupled to the power controller; and in response to determining that the output signal has the first level, turning off, by the power controller, the one or more power stages.

The foregoing and other described implementations can each, optionally, include one or more of the following features:
A first feature, combinable with any of the following features, where the method includes in response to determining that the output signal has the second level, maintaining, by the power controller, a current operation status of the one or more power stages.

A second feature, combinable with any of the previous or following features, where the method includes: based on the measurement voltage being smaller than the reference voltage, generating, by the comparator, the output signal having the first level; and based on the measurement voltage being greater than or equal to the reference voltage, generating, by the comparator, the output signal having the second level.

A third feature, combinable with any of the previous or following features, where the sense probe is spaced apart from the ground probe by a distance smaller than or equal to 10 mm.

A fourth feature, combinable with any of the previous or following features, where the second resistor has a resistance in a range between 0.8 megohms and 1.2 megohms.

Implementations of the subject matter and the functional operations described in this specification can be implemented in digital electronic circuitry, in tangibly embodied computer software or firmware, in computer hardware, including the structures disclosed in this specification and their structural equivalents, or in combinations of one or more of them. Software implementations of the described subject matter can be implemented as one or more computer programs, that is, one or more modules of computer program instructions encoded on a tangible, non-transitory, computer-readable medium for execution by, or to control the operation of, a computer or computer-implemented system. Alternatively, or additionally, the program instructions can be encoded in/on an artificially generated propagated signal, for example, a machine-generated electrical, optical, or electromagnetic signal that is generated to encode information for transmission to a receiver apparatus for execution by a computer or computer-implemented system. The computer-storage medium can be a machine-readable storage device, a machine-readable storage substrate, a random or serial access memory device, or a combination of computer-storage mediums. Configuring one or more computers means that the one or more computers have installed hardware, firmware, or software (or combinations of hardware, firmware, and software) so that when the software is executed by the one or more computers, particular computing operations are performed. The computer storage medium is not, however, a propagated signal.

The term "real-time," "real time," "realtime," "real (fast) time (RFT)," "near(ly) real-time (NRT)," "quasi real-time," or similar terms (as understood by one of ordinary skill in the art), means that an action and a response are temporally proximate such that an individual perceives the action and the response occurring substantially simultaneously. For example, the time difference for a response to display (or for an initiation of a display) of data following the individual's action to access the data can be less than 1 millisecond (ms), less than 1 second (s), or less than 5 s. While the requested data need not be displayed (or initiated for display) instantaneously, it is displayed (or initiated for display) without any intentional delay, taking into account processing limitations of a described computing system and time required to, for example, gather, accurately measure, analyze, process, store, or transmit the data.

The terms "data processing apparatus," "computer," "computing device," or "electronic computer device" (or an equivalent term as understood by one of ordinary skill in the art) refer to data processing hardware and encompass all kinds of apparatuses, devices, and machines for processing data, including by way of example, a programmable processor, a computer, or multiple processors or computers. The computer can also be, or further include special-purpose logic circuitry, for example, a central processing unit (CPU), a field-programmable gate array (FPGA), or an application-specific integrated circuit (ASIC). In some implementations, the computer or computer-implemented system or special-purpose logic circuitry (or a combination of the computer or computer-implemented system and special-purpose logic circuitry) can be hardware- or software-based (or a combination of both hardware- and software-based). The computer can optionally include code that creates an execution environment for computer programs, for example, code that constitutes processor firmware, a protocol stack, a database management system, an operating system, or a combination of execution environments. The present disclosure contemplates the use of a computer or computer-implemented system with an operating system, for example LINUX, UNIX, WINDOWS, MAC OS, ANDROID, or IOS, or a combination of operating systems.

The term "and/or" can refer to and encompasses any and all possible combinations of one or more of the associated listed terms. For example, the term "A and/or B" means that either option A, option B, or both options A and B are possible, where A and B may be singular or plural.

A computer program, which can also be referred to or described as a program, software, a software application, a unit, a module, a software module, a script, code, or other component can be written in any form of programming language, including compiled or interpreted languages, or declarative or procedural languages, and it can be deployed in any form, including, for example, as a stand-alone program, module, component, or subroutine, for use in a computing environment. A computer program can, but need not, correspond to a file in a file system. A program can be stored in a portion of a file that holds other programs or data, for example, one or more scripts stored in a markup language document, in a single file dedicated to the program in question, or in multiple coordinated files, for example, files that store one or more modules, sub-programs, or portions of code. A computer program can be deployed to be executed on one computer or on multiple computers that are located at one site or distributed across multiple sites and interconnected by a communication network.

While portions of the programs illustrated in the various figures can be illustrated as individual components, such as units or modules, that implement described features and functionality using various objects, methods, or other processes, the programs can instead include a number of sub-units, sub-modules, third-party services, components, libraries, and other components, as appropriate. Conversely, the features and functionality of various components can be combined into single components, as appropriate. Thresholds used to make computational determinations can be statically, dynamically, or both statically and dynamically determined.

Described methods, processes, or logic flows represent one or more examples of functionality consistent with the present disclosure and are not intended to limit the disclosure to the described or illustrated implementations, but to be accorded the widest scope consistent with described principles and features. The described methods, processes, or logic flows can be performed by one or more programmable computers executing one or more computer programs to perform functions by operating on input data and generating output data. The methods, processes, or logic flows can also be performed by, and computers can also be implemented as, special-purpose logic circuitry, for example, a CPU, an FPGA, or an ASIC.

Computers for the execution of a computer program can be based on general or special-purpose microprocessors, both, or another type of CPU. Generally, a CPU will receive instructions and data from and write to a memory. The essential elements of a computer are a CPU, for performing or executing instructions, and one or more memory devices for storing instructions and data. Generally, a computer will also include, or be operatively coupled to, receive data from or transfer data to, or both, one or more mass storage devices for storing data, for example, magnetic, magneto-optical disks, or optical disks. However, a computer need not have such devices. Moreover, a computer can be embedded in another device, for example, a mobile telephone, a personal digital assistant (PDA), a mobile audio or video player, a game console, a global positioning system (GPS) receiver, or a portable memory storage device, for example, a universal serial bus (USB) flash drive, to name just a few.

Non-transitory computer-readable media for storing computer program instructions and data can include all forms of permanent/non-permanent or volatile/non-volatile memory, media and memory devices, including by way of example semiconductor memory devices, for example, random access memory (RAM), read-only memory (ROM), phase change memory (PRAM), static random access memory (SRAM), dynamic random access memory (DRAM), erasable programmable read-only memory (EPROM), electrically erasable programmable read-only memory (EEPROM), and flash memory devices; magnetic devices, for example, tape, cartridges, cassettes, internal/removable disks; magneto-optical disks; and optical memory devices, for example, digital versatile/video disc (DVD), compact disc (CD)-ROM, DVD+/-R, DVD-RAM, DVD-ROM, high-definition/density (HD)-DVD, and BLU-RAY/BLU-RAY DISC (BD), and other optical memory technologies. The memory can store various objects or data, including caches, classes, frameworks, applications, modules, backup data, jobs, web pages, web page templates, data structures, database tables, repositories storing dynamic information, or other appropriate information including any parameters, variables, algorithms, instructions, rules, constraints, or references. Additionally, the memory can include other appropriate data, such as logs, policies, security or access data, or reporting files. The processor and the memory can be supplemented by, or incorporated in, special-purpose logic circuitry.

To provide for interaction with a user, implementations of the subject matter described in this specification can be implemented on a computer having a display device, for example, a cathode ray tube (CRT), liquid crystal display (LCD), light emitting diode (LED), or plasma monitor, for displaying information to the user and a keyboard and a pointing device, for example, a mouse, trackball, or trackpad by which the user can provide input to the computer. Input can also be provided to the computer using a touchscreen, such as a tablet computer surface with pressure sensitivity or a multi-touch screen using capacitive or electric sensing. Other types of devices can be used to interact with the user. For example, feedback provided to the user can be any form of sensory feedback (such as, visual, auditory, tactile, or a combination of feedback types). Input from the user can be received in any form, including acoustic, speech, or tactile input. In addition, a computer can interact with the user by sending documents to and receiving documents from a client computing device that is used by the user (for example, by sending web pages to a web browser on a user's mobile computing device in response to requests received from the web browser).

The term "graphical user interface (GUI) can be used in the singular or the plural to describe one or more graphical user interfaces and each of the displays of a particular graphical user interface. Therefore, a GUI can represent any graphical user interface, including but not limited to, a web browser, a touch screen, or a command line interface (CLI) that processes information and efficiently presents the information results to the user. In general, a GUI can include a number of user interface (UI) elements, some or all associated with a web browser, such as interactive fields, pull-down lists, and buttons. These and other UI elements can be related to or represent the functions of the web browser.

Implementations of the subject matter described in this specification can be implemented in a computing system that includes a back-end component, for example, as a data server, or that includes a middleware component, for example, an application server, or that includes a front-end component, for example, a client computer having a graphical user interface or a Web browser through which a user can interact with an implementation of the subject matter described in this specification, or any combination of one or more such back-end, middleware, or front-end components. The components of the system can be interconnected by any form or medium of wireline or wireless digital data communication (or a combination of data communication), for example, a communication network. Examples of communication networks include a local area network (LAN), a radio access network (RAN), a metropolitan area network (MAN), a wide area network (WAN), Worldwide Interoperability for Microwave Access (WIMAX), a wireless local area network (WLAN) using, for example, 502.11x or other protocols, all or a portion of the Internet, another communication network, or a combination of communication networks. The communication network can communicate with, for example, internet Protocol (IP) packets, frame relay frames, Asynchronous Transfer Mode (ATM) cells, voice, video, data, or other information between network nodes.

The computing system can include clients and servers. A client and server are generally remote from each other and typically interact through a communication network. The relationship of client and server arises by virtue of computer programs running on the respective computers and having a client-server relationship to each other.

While this specification contains many specific implementation details, these should not be construed as limitations on the scope of any inventive concept or on the scope of what can be claimed, but rather as descriptions of features that can be specific to particular implementations of particular inventive concepts. Certain features that are described in this specification in the context of separate implementations can also be implemented, in combination, in a single implementation. Conversely, various features that are described in the context of a single implementation can also be implemented in multiple implementations, separately, or in any sub-combination. Moreover, although previously described features can be described as acting in certain combinations and even initially claimed as such, one or more features from a claimed combination can, in some cases, be excised from the combination, and the claimed combination can be directed to a sub-combination or variation of a sub-combination.

Particular implementations of the subject matter have been described. Other implementations, alterations, and permutations of the described implementations are within the scope of the following claims as will be apparent to those skilled in the art. While operations are depicted in the drawings or claims in a particular order, this should not be understood as requiring that such operations be performed in the particular order shown or in sequential order, or that all illustrated operations be performed (some operations can be considered optional), to achieve desirable results. In certain circumstances, multitasking or parallel processing (or a combination of multitasking and parallel processing) can be advantageous and performed as deemed appropriate.

The separation or integration of various system modules and components in the previously described implementations should not be understood as requiring such separation or integration in all implementations, and it should be understood that the described program components and systems can generally be integrated together in a single software product or packaged into multiple software products.

Accordingly, the previously described example implementations do not define or constrain the present disclosure. Other changes, substitutions, and alterations are also possible without departing from the scope of the present disclosure.

Furthermore, any claimed implementation is considered to be applicable to at least a computer-implemented method; a non-transitory, computer-readable medium storing computer-readable instructions to perform the computer-implemented method; and a computer system comprising a computer memory interoperably coupled with a hardware processor configured to perform the computer-implemented method or the instructions stored on the non-transitory, computer-readable medium.

### EMBODIMENTS

Although the present invention is defined in the claims, it should be understood that the present invention can also (alternatively) be defined in accordance with the following embodiments:
1. A device, comprising:
   a circuit comprising:
      a first resistor, wherein the first resistor comprises a ground probe and a sense probe spaced apart from the ground probe, wherein the first resistor has a resistance that varies based on a presence or absence of a liquid between the ground probe and the sense probe; and
      a second resistor coupled to the sense probe, wherein the circuit is configured to provide a measurement voltage indicating the resistance of the first resistor;
   a comparator configured to:
      receive the measurement voltage and a reference voltage; and
      generate an output signal based on a comparison result between the measurement voltage and the reference voltage, wherein the output signal has one of a first level or a second level, the first level indicates the presence of the liquid, and the second level indicates the absence of the liquid; and
   a voltage regulator comprising a power controller and one or more power stages coupled to the power controller, wherein the power controller is configured to:
      receive the output signal from the comparator; and
      in response to determining that the output signal has the first level, turn off the one or more power stages.
2. The device of embodiment 1, wherein the power controller is configured to, in response to determining that the output signal has the second level, maintain a current operation status of the one or more power stages.
3. The device of embodiment 1, wherein the comparator is configured to:
   based on the measurement voltage being smaller than the reference voltage, generate the output signal having the first level; and
   based on the measurement voltage being greater than or equal to the reference voltage, generate the output signal having the second level.
4. The device of embodiment 3, wherein the first level is lower than the second level.
5. The device of embodiment 1, wherein the second resistor has a resistance in a range between 0.8 megohms and 1.2 megohms.
6. The device of embodiment 1, wherein the sense probe is spaced apart from the ground probe by a distance smaller than or equal to 10 mm.
7. The device of embodiment 1, wherein the voltage regulator comprises a multi-phase voltage regulator configured to:
   supply a voltage to at least one processor; and
   in response to determining that the output signal has the first level, terminate the voltage supplied to the at least one processor.
8. A system, comprising:
   one or more processors; and
   a voltage regulator comprising a power controller and one or more power stages coupled to the power controller, wherein the voltage regulator is configured to supply a voltage to the one or more processors;
   a liquid detector coupled to the voltage regulator and comprising:
      a circuit comprising:
         a first resistor, wherein the first resistor includes a ground probe and a sense probe spaced apart from the ground probe, the first resistor has a resistance that varies based on a presence or absence of a liquid between the ground probe and the sense probe; and
         a second resistor coupled to the sense probe, wherein the circuit is configured to provide a measurement voltage indicating the resistance of the first resistor; and
      a comparator configured to receive the measurement voltage and a reference voltage and generate an output signal based on a comparison result between the measurement voltage and the reference voltage, wherein the output signal has one of a first level or a second level, the first level indicates the presence of the liquid, and the second level indicates the absence of the liquid; and
   wherein the power controller of the voltage regulator is configured to (i) receive, from the comparator, the output signal, and (ii) in response to determining that the output signal has the first level, terminate the voltage supplied to the one or more processors by turning off the one or more power stages.
9. The system of embodiment 8, wherein the power controller is configured to, in response to determining that the output signal has the second level, maintain a current operation status of the one or more power stages.
10. The system of embodiment 8, wherein the comparator is configured to:
   based on the measurement voltage being smaller than the reference voltage, generate the output signal having the first level; and
   based on the measurement voltage being greater than or equal to the reference voltage, generate the output signal having the second level.
11. The system of embodiment 8, wherein the sense probe is spaced apart from the ground probe by a distance smaller than or equal to 10 mm.
12. The system of embodiment 8, wherein the sense probe is positioned adjacent to the one or more power stages.
13. The system of embodiment 8, comprising:
   a cooler comprising the liquid and disposed adjacent to the one or more power stages, wherein the cooler is configured to decrease a temperature surrounding the one or more power stages,
   wherein the sense probe is positioned between the cooler and the one or more power stages.
14. The system of embodiment 8, wherein the voltage regulator comprises an input pin configured to receive the output signal of the comparator, and
   wherein the liquid detector and the input pin are positioned on a same side of the voltage regulator.
15. The system of embodiment 8, wherein the voltage regulator comprises a multi-phase voltage regulator.
16. A method, comprising:
   detecting, by a circuit, a presence of a liquid, the circuit comprising a first resistor and a second resistor, the first resistor including a ground probe and a sense probe spaced apart from the ground probe, the first resistor having a resistance that varies based on the presence or absence of the liquid between the ground probe and the sense probe, the second resistor being coupled to the sense probe;
   receiving, by a comparator coupled to the circuit, (i) a measurement voltage from the circuit, the measurement voltage indicating the resistance of the first resistor; and (ii) a reference voltage;
   generating, by the comparator, an output signal based on a comparison result between the measurement voltage and the reference voltage, the output signal having one of a first level or a second level, the first level indicating the presence of the liquid, the second level indicating the absence of the liquid;
   receiving, by a voltage regulator, the output signal from the comparator, the voltage regulator comprising a power controller and one or more power stages coupled to the power controller; and
   in response to determining that the output signal has the first level, turning off, by the power controller, the one or more power stages.
17. The method of embodiment 16, comprising:
   in response to determining that the output signal has the second level, maintaining, by the power controller, a current operation status of the one or more power stages.
18. The method of embodiment 16, comprising:
   based on the measurement voltage being smaller than the reference voltage, generating, by the comparator, the output signal having the first level; and
   based on the measurement voltage being greater than or equal to the reference voltage, generating, by the comparator, the output signal having the second level.
19. The method of embodiment 16, wherein the sense probe is spaced apart from the ground probe by a distance smaller than or equal to 10 mm.
20. The method of embodiment 16, wherein the second resistor has a resistance in a range between 0.8 megohms and 1.2 megohms.

## Claims

1. A device, comprising:
a circuit comprising:
a first resistor, wherein the first resistor comprises a ground probe and a sense probe spaced apart from the ground probe, wherein the first resistor has a resistance that varies based on a presence or absence of a liquid between the ground probe and the sense probe; and
a second resistor coupled to the sense probe, wherein the circuit is configured to provide a measurement voltage indicating the resistance of the first resistor;
a comparator configured to:
receive the measurement voltage and a reference voltage; and
generate an output signal based on a comparison result between the measurement voltage and the reference voltage, wherein the output signal has one of a first level or a second level, the first level indicates the presence of the liquid, and the second level indicates the absence of the liquid; and
a voltage regulator comprising a power controller and one or more power stages coupled to the power controller, wherein the power controller is configured to:
receive the output signal from the comparator; and
in response to determining that the output signal has the first level, turn off the one or more power stages.

2. The device of claim 1, wherein the power controller is configured to, in response to determining that the output signal has the second level, maintain a current operation status of the one or more power stages.

3. The device of any one of claims 1 or 2, wherein the comparator is configured to:
based on the measurement voltage being smaller than the reference voltage, generate the output signal having the first level; and
based on the measurement voltage being greater than or equal to the reference voltage, generate the output signal having the second level; optionally wherein the first level is lower than the second level.

4. The device of any one of claims 1 to 3, wherein the second resistor has a resistance in a range between 0.8 megohms and 1.2 megohms; and/or
wherein the sense probe is spaced apart from the ground probe by a distance smaller than or equal to 10 mm.

5. The device of any one of claims 1 to 4, wherein the voltage regulator comprises a multi-phase voltage regulator configured to:
supply a voltage to at least one processor; and
in response to determining that the output signal has the first level, terminate the voltage supplied to the at least one processor.

6. A system, comprising:
one or more processors; and
a voltage regulator comprising a power controller and one or more power stages coupled to the power controller, wherein the voltage regulator is configured to supply a voltage to the one or more processors;
a liquid detector coupled to the voltage regulator and comprising:
a circuit comprising:
a first resistor, wherein the first resistor includes a ground probe and a sense probe spaced apart from the ground probe, the first resistor has a resistance that varies based on a presence or absence of a liquid between the ground probe and the sense probe; and
a second resistor coupled to the sense probe, wherein the circuit is configured to provide a measurement voltage indicating the resistance of the first resistor; and
a comparator configured to receive the measurement voltage and a reference voltage and generate an output signal based on a comparison result between the measurement voltage and the reference voltage, wherein the output signal has one of a first level or a second level, the first level indicates the presence of the liquid, and the second level indicates the absence of the liquid; and
wherein the power controller of the voltage regulator is configured to (i) receive, from the comparator, the output signal, and (ii) in response to determining that the output signal has the first level, terminate the voltage supplied to the one or more processors by turning off the one or more power stages.

7. The system of claim 6, wherein the power controller is configured to, in response to determining that the output signal has the second level, maintain a current operation status of the one or more power stages.

8. The system of any one of claims 6 or 7, wherein the comparator is configured to:
based on the measurement voltage being smaller than the reference voltage, generate the output signal having the first level; and
based on the measurement voltage being greater than or equal to the reference voltage, generate the output signal having the second level; optionally
wherein the first level is lower than the second level.

9. The system of any one of claims 6 to 8, wherein the sense probe is spaced apart from the ground probe by a distance smaller than or equal to 10 mm; and/or wherein the sense probe is positioned adjacent to the one or more power stages.

10. The system of any one of claims 6 to 9, comprising:
a cooler comprising the liquid and disposed adjacent to the one or more power stages, wherein the cooler is configured to decrease a temperature surrounding the one or more power stages,
wherein the sense probe is positioned between the cooler and the one or more power stages.

11. The system of any one of claims 6 to 10, wherein the voltage regulator comprises an input pin configured to receive the output signal of the comparator, and
wherein the liquid detector and the input pin are positioned on a same side of the voltage regulator; and/or
wherein the voltage regulator comprises a multi-phase voltage regulator.

12. A method, comprising:
detecting, by a circuit, a presence of a liquid, the circuit comprising a first resistor and a second resistor, the first resistor including a ground probe and a sense probe spaced apart from the ground probe, the first resistor having a resistance that varies based on the presence or absence of the liquid between the ground probe and the sense probe, the second resistor being coupled to the sense probe;
receiving, by a comparator coupled to the circuit, (i) a measurement voltage from the circuit, the measurement voltage indicating the resistance of the first resistor; and (ii) a reference voltage;
generating, by the comparator, an output signal based on a comparison result between the measurement voltage and the reference voltage, the output signal having one of a first level or a second level, the first level indicating the presence of the liquid, the second level indicating the absence of the liquid;
receiving, by a voltage regulator, the output signal from the comparator, the voltage regulator comprising a power controller and one or more power stages coupled to the power controller; and
in response to determining that the output signal has the first level, turning off, by the power controller, the one or more power stages.

13. The method of claim 12, comprising:
in response to determining that the output signal has the second level, maintaining, by the power controller, a current operation status of the one or more power stages.

14. The method of any one of claims 12 or 13, comprising:
based on the measurement voltage being smaller than the reference voltage, generating, by the comparator, the output signal having the first level; and
based on the measurement voltage being greater than or equal to the reference voltage, generating, by the comparator, the output signal having the second level; optionally
wherein the first level is lower than the second level.

15. The method of any one of claims 12 to 14, wherein the sense probe is spaced apart from the ground probe by a distance smaller than or equal to 10 mm; and/or wherein the second resistor has a resistance in a range between 0.8 megohms and 1.2 megohms.
